Europäisches Patentamt

European Patent Office

Office européen des brevets

(11) Publication number: **0 104 675**
**B1**

(12) **EUROPEAN PATENT SPECIFICATION**

(45) Date of publication of patent specification: **04.12.85**

(21) Application number: **83201128.2**

(22) Date of filing: **29.07.83**

(51) Int. Cl.⁴: **G 02 F 1/09, H 01 F 10/12,
H 01 S 3/083, G 11 C 13/06**

(54) Magneto-optical element on the basis of Pt-Mn-Sb.

(30) Priority: **24.08.82 NL 8203296**

(43) Date of publication of application:
**04.04.84 Bulletin 84/14**

(45) Publication of the grant of the patent:
**04.12.85 Bulletin 85/49**

(84) Designated Contracting States:
**DE FR GB NL SE**

(56) References cited:
**US-A-3 838 450**
**US-A-3 927 946**

**TRANSACTIONS OF THE JAPANESE
INSTITUTE OF METALS, vol. 17, no. 4, April
1976, pages 220-226, Aoba Araniaki, Sendai,
JP, K. WATANABE: "Magnetic properties of
Clb-type Mn base compounds"**

(73) Proprietor: **N.V. Philips' Gloeilampenfabrieken
Groenewoudseweg 1
NL-5621 BA Eindhoven (NL)**

(72) Inventor: **Van Engen, Pieter Geert
c/o INT. OCTROOIBUREAU B.V. Prof. Holstlaan 6
NL-5656 AA Eindhoven (NL)**
Inventor: **Buschow, Kurt Heinz Jürgen
c/o INT. OCTROOIBUREAU B.V. Prof. Holstlaan 6
NL-5656 AA Eindhoven (NL)**
Inventor: **Jongebreur, Ronald
c/o INT. OCTROOIBUREAU B.V. Prof. Holstlaan 6
NL-5656 AA Eindhoven (NL)**

(74) Representative: **Koppen, Jan et al
INTERNATIONAAL OCTROOIBUREAU B.V. Prof.
Holstlaan 6
NL-5656 AA Eindhoven (NL)**

(56) References cited:

**IEEE TRANSACTIONS ON MAGNETICS, vol.
MAG-8, September 1972, pages 481-486, New
York, US, E. FELDTKELLER: "Suitability of MnBi
and Mnl-xTixBi films for magnetooptic
memories"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 104 675 B1

(56) References cited:

JOURNAL OF APPLIED PHYSICS, vol. 51, no. 7, July 1980, pages 3949-3952, American Institute of Physics, New York, US, M.S. VIJAYARAGHAVAN et al.: "Magneto-optical properties of tin substituted MnSb films"

APPLIED PHYSICS LETTERS, vol. 42, no. 2, 15th January 1983, pages 202-204, American Institute of Physics, New York, US, P.G. VAN ENGEN et al.: "PtMnSb, a material with very high magneto-optical Kerr effect"

APPLIED PHYSICS LETTERS

## Description

The invention relates to a magneto-optical element comprising a substrate which carries a magneto-optically active layer consisting of a metallic ferromagnetic material, in which a change of the state of polarization of a polarized light beam which is reflected or passes through by the magneto-optical layer takes place in accordance with the magnetization in the area where the light beam impinges on the layer. The variation of the state of polarization may be a variation of the ellipticity and/or of the orientation of the major axis of the ellipse of polarization. For example, dextrorotation or levorotation of said major axis occurs, dependent on the fact whether the magnetization responsible for the rotation influences the light beam with a positive or a negative polarity. When an analyzer plus a linearly birefringent element are placed in the light path of a light beam reflected by or which has passed through a magneto-optical layer, an elliptically polarized light beam emanating from the analyzer will have different intensities dependent on the produced variation of the state of polarization.

Magneto-optical effects may be used in a number of different magneto-optical devices. For example, recorded magnetic data can be detected by means of a polarized, focused light beam, said light beam being reflected by the recording medium at the area of the magnetic data. The differences in intensity of the reflected light beam represent the recorded magnetic data. All this may be carried out, for example, in such manner that an analyser (plus linearly birefringent element) placed in the light path maximally transmits light when a place having a magnetization of one polarity is scanned, and minimally transmits light when a place having an equally large magnetization but opposite polarity is scanned. In this manner data recorded magnetically can be read optically.

Another application is as a magneto-optical mirror in ring laser gyroscopes.

The material which at room temperature in reflection shows the so far known largest magneto-optical effect is MnBi. Magneto-optical films of this material are described in "IEEE Transactions on Magnetics" Vol. MAG—8 (1972), pages 481-486. However, said material is not stable crystallographically. This means that upon heating to temperatures in the proximity of its Curie temperature it shows a crystallographic transition to a phase having a considerably smaller magneto-optical effect. As a result of this MnBi is not suitable for repeatedly recording magnetic data thermomagnetically. As a matter of fact, in a thermomagnetic recording process the material should be locally heated to a temperature in the proximity of its Curie temperature so as to be able to reverse the direction of magnetization.

Other metallic magneto-optical materials, for example, GdCo and GdFe are crystallographically stable but show a considerably smaller magneto-optical effect than MnBi.

In this connection it is to be noted that certain oxidic materials (ferrites and garnets) in transmission have a very high magneto-optical Q-factor (defined as a Faraday-effect divided by the absorption coefficient). However, said property of oxidic materials is associated with a low absorption as a result of which they must have a rather large thickness (approximately 0.5 μm) when used in recording devices. This means that writing is difficult (requires much electric power) and that in fact very small bits cannot be written (non-optimum recording density). Magneto-optic metallic materials can be used in reflection, for which thin layers (thickness smaller than 0.5 μm, in particular between 0.005 and 0.2 μm) are suitable. Recording information in these thin layers requires little electric power (the absorption of metal layers is high) and writing very small bits has proved to be possible. Moreover, thin metal films are cheap to make as compared with, for example, mono-crystalline garnet films. All these factors cause the interest in metal films for magneto-optical applications to be great.

It is the object of the invention to provide a magneto-optical element having a metallic magneto-optical layer which combines chemical stability with an optimum magneto-optical effect, in particular in reflection.

This object is achieved by a magneto-optical element having a magneto-optically active layer which consists of an alloy having a composition in the single phase homogeneity region of the $C1_b$ structure in the Pt-Mn-Sb system. A characteristic composition in this region is $Pt_1Mn_1Sb_1$.

The magnetic (but not the magneto-optic) properties of $C1_b$ type Pt-Mn-Sb have been studied in the article "Transactions of the Japanese Institute of Metals" Vol. 17 (1976), pages 220—226. It has now been found that the magneto-optical (Kerr)-effect (rotation of the plane of polarization in the reflective mode) of a layer of this type of alloy in the wavelength range from 600—900 nm is more than 50% larger than the Kerr-effect of Mn-Bi layers and certainly 100% larger than the Kerr-effect of rare earth-iron garnet layers, while this type of alloy is crystallographically stable up to a few hundred degrees Celsius above its Curie temperature. The magneto-optical Faraday-effect (rotation of the plane of polarization in the transmission mode) of Pt-Mn-Sb further proves to be the next largest of the so far known metallic magneto-optical materials to the Faraday-effect of Mn-Bi.

A first embodiment of a device according to the invention relates to a magneto-optical device for thermomagnetically writing and magneto-optically reading information, comprising a magneto-optical element as described above and further comprising a source of radiation, means to direct radiation produced by the source of radiation onto selected areas of the magneto-optically active layer and to increase the temperature thereof for a short period of time, means to magnetize the layer in a direction perpendicular to its surface, and magneto-optical reading means. In a magneto-optical device the use of magneto-optically active Pt-Mn-Sb based layers leads to an improvement of the contrast and in particular to a significant improvement of the signal-to-noise ratio.

A second embodiment of a device in accordance with the invention relates to a magneto-optical mirror for giving upon reflection a non-reciprocal phase shift to an incident plane-polarized light beam, comprising a magneto-optical element as described above, and further comprising means to subject the magneto-optically active layer to a magnetic field which is directed perpendicularly to the plane of incidence of the plane-polarized light beam. The use of magneto-optically active Pt-Mn-Sb based layers in a magnetic mirror leads to an increase of the non-reciprocity. Magnetic mirrors are used *inter alia* in ring laser gyroscopes but other applications are also possible, for example, optical insulators, modulators, and filters.

Preferably the Pt-Mn-Sb based magneto-optically active layer is deposited on a substrate in a thickness of 0.005 μm to 0.5 μm.

It is noted that the presence of a second phase, for example, Pt-Mn, is undesirable because it can adversely influence the value of the magneto-optical effect.

The invention will now be described in greater detail, by way of example, with reference to the drawings, in which

Figure 1 shows diagrammatically a device for measuring the Kerr-effect,

Figure 2 is a cross-sectional view through a substrate having a magneto-optical layer.

Figure 3 is a graph showing the double Kerr-rotation $2\varphi_K$ and the double ellipticity $2\varepsilon_K$ of Pt-Mn-Sb plotted as a function of the wavelength $\lambda$ of an incident light beam.

Figure 4 shows diagrammatically a magneto-optical memory device, and

Figure 5 shows diagrammatically an optical ring laser resonant cavity.

The Kerr-rotation is the rotation of the plane of polarization of a linearly polarized light beam upon reflection by a magnetic medium. In particular the reflected beam will no longer be polarized linearly but will be polarized elliptically. The ellipticity of the polarization of the reflected beam is termed the Kerr-ellipticity $\varepsilon_K$. In a magneto-optical recording system the reading signal is determined by a combined Kerr-effect $\theta_K = (\varphi_K^2 + \varepsilon_K^2)^{\frac{1}{2}}$, where $\varphi_K$ is the Kerr-rotation. The sign of the rotation and the ellipticity reverses when the direction of magnetization of the medium is reversed. The Kerr-effect is termed polar Kerr-effect when both the incident light beam and the magnetization are transverse to the reflecting surface. This is the configuration which is suitable for recording purposes.

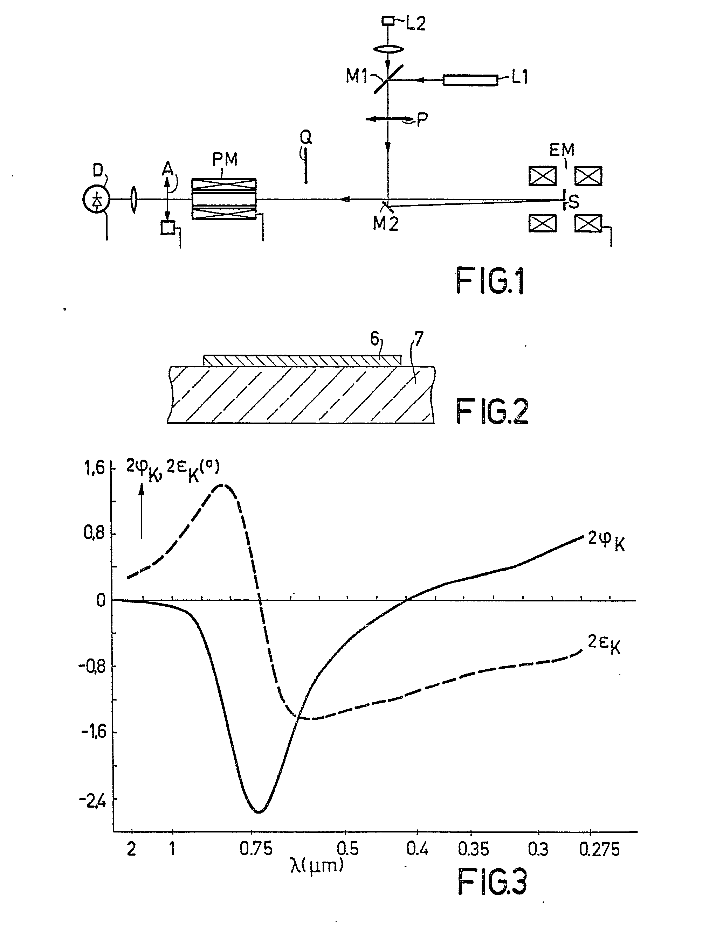

In the measurements of the Kerr-effect of Pt-Mn-Sb the arrangement shown in Figure 1 was used. In the first wavelengths, in which a He-Ne-laser. $L_1$ ($\lambda = 633$ nm) and a Ga-As laser $L_2$ ($\lambda = 830$ nm) were used alternately. The infrared light of laser $L_1$ was collimated and passed by the daylight mirror $M_1$. This mirror reflects the red light of laser $L_1$. A polarizer P polarizes the light in a direction transverse to the plane of incidence of mirror $M_2$. The angle of incidence on Pt-Mn-Sb specimen S is smaller than 0.3°. By means of electromagnet EM, specimen S is magnetized in the direction transverse to its surface, either parallel, or anti-parallel with respect to the incident beam. After reflection the light beam passes through a polarization modulator PM, which modulates the orientation of the ellipse of polarization and an analyzer A. The analyser A is driven by a stepping motor (0.001° per step). The light beam is finally focused on an avalanche photodiode which serves as a detector D. By means of an electronic control system the analyzer is placed in a position in which its axis is perpendicular to the polarization of the light beam after reflection by the surface of specimen S. This position is read. The Kerr-rotation is now measured as follows. First specimen S is magnetically saturated with the magnetization anti-parallel with respect to the incident light beam, the position of the analyzer being registrated. The magnetization is then reversed and the new position of the analyzer is registrated. The difference between the two positions is the double Kerr-rotation. The ellipticity is measured by repeating the above-described measurement with a linear birefringent element (a $\frac{1}{4}\lambda$ plate) placed in front of the modulator PM. After the Kerr-effect had been measured in this manner at two wavelengths, the wavelength range from 280 to 2000 nm was measured by means of a continuously variable light source with monochromator and double refracting plates (Figure 3). The double Kerr-rotation $2\varphi_K$ of Pt-Mn-Sb proves to have a maximum of more than 2.5° at $\lambda = 720$ nm (for comparison: the maximum double Kerr rotation of MnBi is 1.5°). Below a comparison is given between the Kerr-rotation $\varphi_K$, the Kerr-ellipticity $\varepsilon_K$ and the combined Kerr-effect $\theta_K = (\varphi_K^2 + \varepsilon_K^2)^{\frac{1}{2}}$ of MnBi and $Pt_1Mn_1Sb_1$, at $\lambda = 633$ nm:

| | $\varphi_K^{(o)}$ | $\varepsilon_K^{(o)}$ | $\theta_K^{(o)}$ |
|---|---|---|---|
| MnBi | 0.56 | 0.48 | 0.73 |
| PtMnSb | 0.93 | 0.61 | 1.15 |

A magneto-optical element on the basis of Pt-Mn-Sb may have the construction shown in Figure 2 in which a thin layer 6 of monophase Pt-Mn-Sb having a crystal structure of the type C1$_b$ (the structure of MgAgAs) is deposited on a substrate 7 of, for example, glass or quartz by means of sputtering or evaporation. The thickness of the layer 6 is typically between 0.005 and 0.5 μm.

The magneto-optical element of Figure 2 may be used in a magneto-optical recording device.

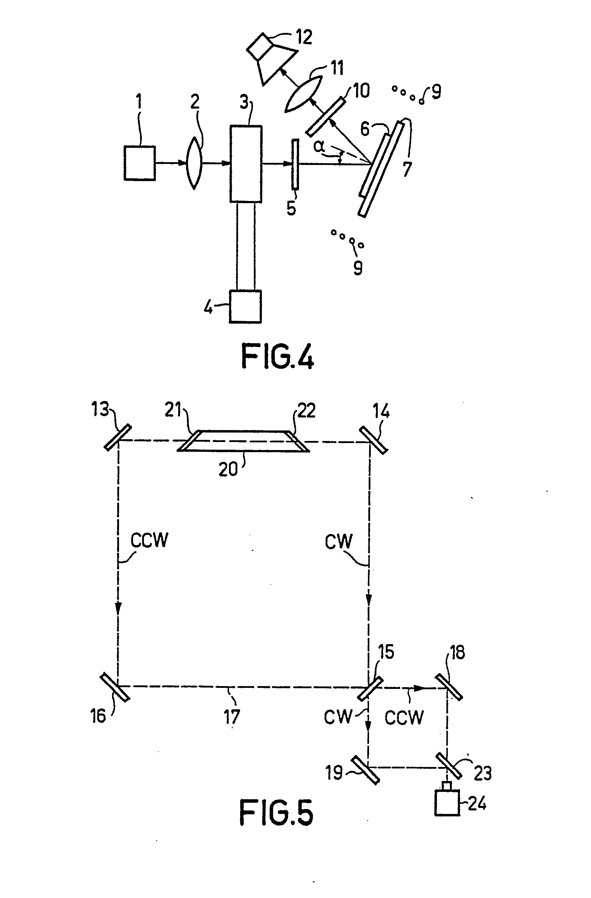

Figure 4 shows a magneto-optical device in the form of a device for thermomagnetic recording of data with magneto-optical reading, partly in the form of a drawing and partly in the form of a block diagram. The device comprises a magneto-optical recording element comprising a layer 6 of magnetizable material deposited on a substrate 7 and having a microstructure favouring uniaxial magnetic anisotropy. The magnetizable material has a composition based on Pt-Mn-Sb. For writing information bits the device comprises a source of radiation 1. This preferably is a laser. Source 1 produces energy pulses which after focusing by the lens 2 and deflection by the deflection device 3 impinge on a selected area, or address, of the layer 6. (For clarity the angle $\alpha$ between the incident light beam and the normal is shown to be considerably exaggerated, the mean angle of incidence being about 0°). In this place, a decrease of the coercive force is produced by the increase in temperature generated by the incident radiation. The deflection device 3 is controlled by an addressing device 4. Simultaneously, by energizing the coil 9, a magnetic field having a suitable field strength is switched-on so as to orient the magnetization of the layer upwards or downwards transverse to the surface. For reading the stored information a polarizer 5 is placed between the deflection device 3 and the layer 6 and an analyzer 10, a lens 11 and a photo-electric detector 12 in this sequence are placed in the direction of the reflected beam. For reading, the source of radiation 1 is adapted to provide a beam of radiation having a significantly lower energy than for writing. The analyzer 10 is rotated so that the light reflected by the portions of the layer 6 which are magnetized in a previously determined direction, is extinguished. This in the case that $\varepsilon_K = O$. If $\varepsilon_K \neq O$ the analyzer may be combined with a linear birefringent element for rendering the elliptically polarized light linearly polarized. Hereby only light which is reflected by the portions of the layer which are magnetized opposite to the first-mentioned direction is incident on the photo-electric detector 12.

The magnetic element of Figure 2 can also be used as a magnetic mirror for giving a non-reciprocal phase shift to an incident plane-polarized light beam, for example in a ring laser. A ring laser comprises an optical cavity as shown diagrammatically in Figure 5, having components such as a number of mirrors 13, 14, 15, 16 destined to convey light waves around a closed loop which light waves are introduced into the cavity by an active laser medium. In Figure 5 an active laser medium, for example a standard He-Ne-gas mixture, excited by conventional radio frequency means and enclosed in a glass tube 20, emits light waves in both directions along its longitudinal axis through optically flat plates 21 and 22 sealing the ends of the tube 20. The mirrors 13, 14, 15 and 16 forming an optical resonant cavity successively reflect contradirectional light waves around a closed loop 17. The optically flat plates 11 and 12 enclose such an angle with the longitudinal axis of the tube 20 (the so-called Brewster's angle) that the light waves are polarized in a plane which is parallel to the plane of the optical resonant cavity. Therefore the light waves when incident on the mirrors 13, 14, 15 and 16 are always polarized in the plane of incidence.

A measure of the difference between the frequencies of the contradirectional light waves which occurs as a result of non-reciprocal effects in the optical cavity is obtained by passing a part of the energy in each beam through corner mirror 15 to a combination mechanism which comprises two mirrors 18 and 19 as well as a beam splitter 23 and a photo detector 24. The component of the light beam (CW) which circulates clockwise and which is passed by the mirror 15 reaches the photo detector 24 after reflection by the mirror 19 and the beam splitter 23. In a corresponding manner the part of the counter-clockwise light wave (CCW) which is withdrawn from the cavity is reflected by the mirror 18 and partly by the beam splitter 23 in colinear relationship with the CM light wave passed to the photo detector 24 where the light waves generate an electric signal with their difference frequency.

In order to prevent so-called "mode locking" the optical cavity comprises a non-reciprocal phase shifting element. For this purpose, at the area of mirror 16 which may be of the type of the layer construction shown in Figure 2, a magnetic field is generated. Alternatively, the mirror 16 may be formed of a bulk material having magneto-optic properties, or the mirror 16 may be of the type of layer construction shown in Figure 2, but having additional layers for enhancing the reflection and/or the magneto-optic effect. The magnetization of mirror 16 has such an interaction with the incident (CW) and (CCW) light waves that these are given a differential phase shift upon reflection. As a result of this the (CW) and (CCW) light waves oscillate at different frequencies so that the phenomenon of "mode locking" cannot occur. The magnetization of mirror 16 is oriented perpendicularly to the plane of the optical cavity and the light waves are polarized in the plane of incident of the mirror 16. These conditions in which the transversal Kerr-effect is used provide the desired phase shift while maintaining the polarization of the light waves.

It is noted that the essence of the invention is the use of a room-temperature ferromagnetic material having a composition on the basis of Pt-Mn-Sb. Optionally, e.g. for adjusting the Curie temperature, other metals may be substituted to partly replace Pt or Mn.

**Claims**

1. A magneto-optical element comprising a substrate which carries a magneto-optically active layer consisting of a metallic ferromagnetic material in which a change of the state of polarization of a polarized light beam which is reflected by or passes through the magneto-optically active layer takes places in accordance with the magnetization in the area where the light beam impinges on the layer, characterized in that the magneto-optically active layer consists of an alloy having a composition in the single-phase homogeneity region of the $C1_b$ structure in the Pt-Mn-Sb system.

2. A magneto-optical device for thermo-magnetically writing and magneto-optically reading information comprising a magneto-optical element as claimed in Claim 1, and further comprising a source of radiation, means to direct radiation produced by the source of radiation onto selected areas of the layer to increase the temperature thereof for a short period of time, means to magnetize the layers in a direction perpendicular to its surface, and magneto-optical reading means.

3. A magneto-optical mirror for giving upon reflection a non-reciprocal phase shift to an incident plane-polarized light beam, comprising a magneto-optical element as claimed in Claim 1, and further comprising means to subject the magneto-optically active layer of the element to a magnetic field which is directed perpendicularly to the plane of incidence of the plane-polarized light beam.

4. A magneto-optical element as claimed in Claim 1, characterized in that the magneto-optically active layer has a thickness from 0.005 µm to 0.5 µm.

## Patentansprüche

1. Magnetooptisches Element mit einem Substrat, das eine magnetooptisch aktive Schicht trägt, die aus einem metallischen ferromagnetischen Werkstoff besteht, in dem eine Änderung des Polarisationszustands eines polarisierten Lichtstrahls, den die magnetooptisch aktive Schicht reflektiert oder durchlässt, entsprechend der Magnetisierung im Bereich erfolgt, in dem der Lichtstrahl auf der Schicht trifft, dadurch gekennzeichnet, dass die magnetooptisch aktive Schicht aus einer Legierung besteht, die eine Zusammensetzung im Einphasen-Homogenitätsbereich der $C1_b$-Struktur im Pt-Mn-Sb-System besitzt.

2. Magnetooptische Einrichtung zum thermomagnetischen Schreiben und magnetooptischen Lesen von Information mit einem magnetooptischen Element nach Anspruch 1, und weiter mit einer Strahlungsquelle, Mitteln zum Richten der von der Strahlungsquelle erzeugten Strahlung auf ausgewählte Gebiete der Schicht zum kurzzeitigen Erhöhen ihrer Temperatur, Mitteln zum Magnetisieren der Schicht in einer Richtung senkrecht zu ihrer Oberfläche, und mit magnetooptischen Lesemitteln.

3. Magnetooptischer Spiegel zum Auslösen einer nichtreziproken Phasenverschiebung bei einem auffallenden, linear polarisierten Lichtstrahl bei der Reflektion, mit einem magnetooptischen Element nach Anspruch 1, und weiter mit Mitteln zum Anlegen eines magnetischen Feldes an der magnetooptisch aktiven Schicht des des Elements, wobei das Magnetfeld senkrecht zur Einfallsebene des linear polarisierten Lichtstrahls verläuft.

4. Magnetooptisches Element nach Anspruch 1, dadurch gekennzeichnet, dass die magnetooptisch aktive Schicht eine Dicke von 0,005 µm bis 0,5 µm hat.

## Revendications

1. Elément magnéto-optique, comportant un substrat muni d'une couche magnéto-optiquement active constituée par un matériau ferromagnétique métallique, dans lequel un changement de l'état de polarisation d'un faisceau lumineux polarisé réfléchi par ou traversant la couche magnéto-optiquement active se produit conformément à la magnétisation dans la zone dans laquelle le faisceau lumineux atteint la couche, caractérisé en ce que la couche magnéto-optiquement active est constituée par un alliage présentant une composition dans la région d'homogénéité monophasée de la structure $C1_b$ dans le système Pt-Mn-Sb.

2. Dispositif magnéto-optique pour l'inscription thermomagnétique et la lecture magnéto-optique d'information comprenant un élément magnéto-optique selon la revendication 1, et muni d'une source de rayonnement, de moyens pour diriger le rayonnement produit par la source de rayonnement sur les zones sélectionnées de la couche pour augmenter sa température pendant une courte période, de moyens pour magnétiser la couche dans une direction perpendiculaire à sa surface et de moyens de lecture magnéto-optiques.

3. Miroir magnéto-optique servant à fournir un déphasage non reciproque dans le cas de réflexion à un faisceau lumineux polarisé en plan incident, comportant un élément magnéto-optique selon la revendication 1 et comportant en outre des moyens pour soumettre la couche magnéto-optiquement active de l'élément à un champ magnétique s'étendant perpendiculairement au plan d'incidence du faisceau lumineux polarisé en plan.

4. Elément magnétique selon la revendication 1, caractérisé en ce que la couche magnéto-optiquement active présente une épaisseur comprise entre 0,005 µm et 0,5 µm.

FIG.1

FIG.2

FIG.3

FIG.4

FIG.5